# EUROPÄISCHE PATENTANMELDUNG

(11) **EP 3 489 704 A1**
(43) Veröffentlichungstag der Anmeldung: **29.05.2019**
(21) Anmeldenummer: 17203588.3
(22) Anmeldetag: 24.11.2017
(51) Int. Cl.: G01R 33/34, G01R 33/3415

(54) **LOKALE MRT-SPULE FÜR EINE DENTALE MRT-MESSUNG**

(71) Anmelder: Sirona Dental Systems GmbH, 64625 Bensheim (DE)
(72) Erfinder: WUNDRAK, Stefan, 64625 Bensheim (DE); ULRICI, Johannes, 64285 Darmstadt (DE)
(74) Vertreter: Sommer, Peter

(57) **Zusammenfassung**

Die Erfindung betrifft eine lokale MRT-Spule (1) für eine dentale MRT-Messung eines Patientenkopfes (2), umfassend mindestens zwei Spulenelemente (10, 12, 13, 24, 26). Die lokale MRT-Spule (1) weist dabei mindestens eine geschlossene Aussparung (4) für mindestens einen Teil einer Nase (5) des Patientenkopfes (2) auf, wobei eine Spule (42) mindestens eines Spulenelements (12) um die geschlossene Aussparung (4) herum angeordnet ist und den mindestens einen Teil der Nase (5) des Patientenkopfes (2) umschließt.

## Beschreibung

### Technisches Gebiet

Die Erfindung betrifft eine lokale MRT-Spule für eine dentale MRT-Messung eines Patientenkopfes, umfassend mindestens zwei Spulenelemente.

### Stand der Technik

Aus dem Stand der Technik sind mehrere MRT-Spulen für dentale MRT-Messungen bekannt.

Bei einer dentalen 4-KanalMRT-Spule der Firma Noras werden vier Spulenelemente am Patienten angelegt, wobei für die Nase eine Kerbe vorhanden ist.

DE 102014220116 A1 offenbart eine Hochfrequenzspule für MRT-Messungen an einem Zielvolumen in einem oralen Bereich eines zu untersuchenden Objekts, wobei die Größe einer Windung der Hochfrequenzspule an die Geometrie des Objekts angepasst ist. Auf diese Weise können MRT-Aufnahmen in einem oralen Bereich mit höherer Auflösung und verbessertem Patientenkomfort durchgeführt werden. Die Windung ist dabei auf beiden Seiten eines aufzunehmenden Objekts, wie eines Backenzahns, angeordnet.

Ein Nachteil der bekannten dentalen MRT-Spulen besteht darin, dass die MRT-Spulen entweder nicht nahe genug am Patientenkopf angeordnet werden können, so dass abstehende anatomische Strukturen, wie die Nase und Ohren, dazwischenliegen oder dass die durch die MRT-Spulen aufzunehmenden Aufnahmebereiche begrenzt sind und lediglich Teilbereiche der beiden Kiefer aufnehmen können.

Die Aufgabe der vorliegenden Erfindung besteht daher darin, eine lokale MRT-Spule bereit zu stellen, die möglichst nah am Patientenkopf anliegt und einen Aufnahmebereich aufweist, der dentale Strukturen möglichst umfangreich abdeckt.

### Darstellung der Erfindung

Die Erfindung betrifft eine lokale MRT-Spule für eine dentale MRT-Messung eines Patientenkopfes, umfassend mindestens zwei Spulenelemente. Die lokale MRT-Spule weist dabei mindestens eine geschlossene Aussparung für mindestens einen Teil einer Nase des Patientenkopfes auf, wobei eine Spule mindestens eines Spulenelements um die geschlossene Aussparung herum angeordnet ist und den mindestens einen Teil der Nase des Patientenkopfes umschließt.

Die lokale MRT-Spule für die dentale MRT-Messung ermöglicht einem Zahnarzt insbesondere im Bereich der kieferorthopädischen Behandlungen exakte Informationen und hochauflösende Bilder der aktuellen Zahnstellungen zu erhalten. Mittels der lokalen MRT-Spule können auch mehrere MRT-Aufnahmen der Zahnstellungen und der beiden Kiefer zueinander in regelmäßigen Zeitabständen durchgeführt werden, um den Erfolg einer kieferorthopädischen Behandlung beziehungsweise eines Eingriffs nachvollziehen zu können.

Eine lokale MRT-Spule zur MRT-Messung wird auch im Bereich der Implantologie zur Bildgebung der Nerven und zur Bestimmung der Knochendichte oder als Bildgebungsverfahren zur Tumorsuche verwendet. Die lokale MRT-Spule kann beispielweise eine Multikanal-Hochfrequenz-MRT-Spule sein, die mehrere parallel betriebene Spulenelemente aufweist, die eine parallele Bildgebung ermöglichen, wodurch die Aufnahmezeit einer MRT-Aufnahme verkürzt wird sowie die Auflösung verbessert wird.

Zur Vermessung einer MRT-Aufnahme werden Wasserstoffatome im Objektvolumen, nämlich zumindest in einem Teilbereich des Patientenkopfes, durch ein sehr starkes Magnetfeld ausgerichtet. Zusätzlich zu diesem starken Magnetfeld gibt die MRT-Vorrichtung während der Messung Radiowellen mit einer hohen Frequenz auf das Objekt ab, wodurch sich die parallele Ausrichtung der Wasserstoffkerne im Magnetfeld verändert. Nach jedem Radiowellen-Impuls kehren die Wasserstoffkerne wieder in die Längsrichtung zurück, die durch das starke Magnetfeld vorgegeben ist. Hierbei senden die Atomkerne Radiowellen aus, die während der MRT-Messung gemessen und dann vom Computer zu Bildern zusammengesetzt werden. Eine lokale MRT-Spule wird also verwendet, um diese Signale besser zu empfangen und dient somit als eine Empfangsspule.

Die mindestens zwei Spulenelemente weisen jeweils eine entsprechend geformte Spule auf, wobei zur Verstärkung des Signals in jedes der Spulenelemente ein Vorverstärker integriert sein kann. Dadurch werden eine hohe Signalausbeute und eine verbesserte Bildqualität gewährleistet.

Die lokale MRT-Spule weist mindestens eine geschlossene Aussparung um mindestens einen Teil der Nase auf. Die geschlossene Aussparung ist eine Aussparung, die einen geschlossenen Rand aufweist. Die geschlossene Aussparung kann also eine Öffnung, wie ein rundes Loch, oder auch eine geschlossene Erhebung, wie eine halbkugelförmige Aussparung um die Nase, sein. Die Spule des jeweiligen Spulenelements ist dabei um die geschlossene Aussparung für die Nase angeordnet, so dass die aufzunehmenden Objekte, nämlich Zähne, Nerven, Zahnwurzeln und/oder Kieferknochen, möglichst nah am Spulenelement angeordnet werden.

Die geschlossene Aussparung umschließt dabei mindestens einen Teil der Nase, so dass eine Ebene, die durch einen geschlossenen Rand der geschlossenen Aussparung geht, die Nase in einer vorgegebenen Höhe schneidet.

Ein Vorteil der vorliegenden MRT-Spule besteht darin, dass die geschlossene Aussparung, in Form einer Öffnung oder einer geschlossenen Kuppel, wie einer halbkugelförmigen Kuppel, um die Nase angeordnet wird und dadurch die lokale MRT-Spule möglichst nah am aufzunehmenden Objekt, nämlich den Zähnen, den Zahnwurzeln, den Nerven, dem Zahnfleisch und/oder dem Kieferknochen, positioniert werden kann. Dadurch wird die Signalausbeute erhöht und die Bildqualität der MRT-Aufnahme verbessert.

Ein weiterer Vorteil der vorliegenden lokalen MRT-Spule besteht darin, dass durch die geschlossene Aussparung um die Nase des Patienten eine einfachere Positionierung der MRT-Spule am Patientenkopf ermöglicht wird. Denn ein seitliches Verrutschen der lokalen MRT-Spule wird durch die Nase verhindert.

Die mindestens eine geschlossene Aussparung kann auch als eine ovalförmige Öffnung geformt sein oder der Form der jeweiligen anatomischen Struktur, wie der Nase, entsprechen.

Vorteilhafterweise kann die MRT-Spule eine zweite geschlossene Aussparung für mindestens einen Teil eines Mundes und/oder mindestens einen Teil eines Ohres des Patientenkopfes in einem zweiten Spulenelement aufweisen, wobei eine Spule des zweiten Spulenelements um die zweite geschlossene Aussparung herum angeordnet ist und wobei die zweite geschlossene Aussparung um den Mund, das linke Ohr oder das rechte Ohr angeordnet ist.

Die zweite geschlossene Aussparung wird also um den Mund und/oder um ein Ohr des Patientenkopfes angeordnet, so dass die aufzunehmenden Objektbereiche hinter dem Mund des Patienten, wie Vorderzähne, Zahnwurzeln der Vorderzähne und der entsprechende Kieferknochen, oder die Objektbereiche hinter dem Ohr des Patienten, wie das jeweilige Kiefergelenk, besser aufgenommen werden können.

Vorteilhafterweise kann mindestens eine weitere geschlossene Aussparung in einem weiteren Spulenelement um den Mund, das linke Ohr oder das rechte Ohr angeordnet sein.

Dadurch umfasst eine dritte oder eine vierte Aussparung im entsprechenden Spulenelement den Mund, das linke Ohr oder das rechte Ohr. Dadurch können also aufzunehmende Objektbereiche hinter dem Mund, wie die vorderen Zähne, oder Strukturen hinter dem Ohr, wie das entsprechende Kiefergelenk, genauer vermessen werden.

Vorteilhafterweise kann jedes der Spulenelemente einen durch das Spulenelement definierten begrenzten Aufnahmebereich aufnehmen.

Dadurch wird durch jedes der Spulenelemente ein entsprechender Aufnahmebereich mit einem hohen Signal-Rausch-Verhältnis vermessen. Zur Aufnahme bestimmter Strukturen des Objekts müssen diese Strukturen daher innerhalb des Aufnahmebereichs positioniert werden. Der Aufnahmebereich kann beispielsweise eine bestimmte Form aufweisen, die beispielsweise am mittleren Umfang durch die Spule des Spulenelements begrenzt ist. Die Sensitivität der Spule nimmt mit einem zunehmenden orthogonalen Abstand relativ zur Ebene der Spule ab, so dass ab einer bestimmten Sensitivitätsschwelle das Signal-Rausch-Verhältnis zu hoch wird, um anatomische Strukturen zu erkennen. Diese Sensitivitätsschwelle der jeweiligen Spule kann folglich die Grenze des Aufnahmebereichs definieren.

Vorteilhafterweise kann die MRT-Spule mindestens ein weiteres Spulenelement ohne Aussparung aufweisen, wobei die von den einzelnen Spulenelementen umschlossenen Aufnahmebereiche zusammenhängend sind.

Ein Spulenelement ohne Aussparung weist eine entsprechende Spule und vorteilhafterweise einen Vorverstärker auf. Die Aufnahmebereiche der einzelnen Spulen der Spulenelemente sind dabei so angeordnet, dass die Aufnahmebereiche zusammenhängend sind und damit lückenlos ein zusammenhängendes Volumen des Objekts vermessen können. Die Spulenelemente können beispielsweise um die beiden Kiefer angeordnet sein, sodass die in das Gewebe des Patientenkopfes hineinragenden Aufnahmebereiche sich überlappen und zusammenhängend sind.

Vorteilhafterweise können die einzelnen Spulenelemente relativ zu einer Symmetrieebene des Patientenkopfes symmetrisch angeordnet sein.

Die Symmetrieebene des Patientenkopfes ist durch eine Medianebene definiert. Durch die symmetrische Anordnung der Spulenelemente relativ zur Symmetrieebene wird eine gleichmäßige und symmetrische Abdeckung des aufzunehmenden Bereichs, wie des Oberkiefers oder des Unterkiefers, gewährleistet.

Vorteilhafterweise kann die MRT-Spule auch als eine Anregungsspule verwendet werden, indem zusätzliche Radiowellen ausgesandt werden, um die Atome des Objekts anzuregen.

Vorteilhafterweise können die mindestens zwei Spulenelemente möglichst nah an einem aufzunehmenden Objektbereich positioniert werden, wobei der Objektbereich mindestens einen Zahnbereich, ein linkes Kiefergelenk und/oder ein rechtes Kiefergelenk umfasst.

Durch die nahe Positionierung der Spulenelemente am aufzunehmenden Objektbereich wird die Signalausbeute und damit die Bildqualität verbessert.

Vorteilhafterweise können die durch die einzelnen Spulenelemente definierten Aufnahmebereiche zumindest einen halben Oberkiefer und/oder einen halben Unterkiefer abbilden.

Dadurch ermöglicht die lokale MRT-Spule die Vermessung des kompletten halben Oberkiefers beziehungsweise Unterkiefers.

Vorteilhafterweise können die von den einzelnen Spulenelementen umfassten Aufnahmebereiche den gesamten Oberkiefer und/oder den gesamten Unterkiefer abbilden.

Dadurch wird die Vermessung des gesamten Oberkiefers beziehungsweise Unterkiefers ermöglicht.

Vorteilhafterweise können die MRT-Spule und/oder die einzelnen Spulenelemente mit einer festgelegten Krümmung gekrümmt geformt sein.

Damit können die MRT-Spule und/oder die einzelnen Spulenelemente eine festgelegte beliebige Krümmung aufweisen, wobei die Krümmung beispielweise eine kreisförmige oder eine elliptische Krümmung sein kann. Alternativ kann die MRT-Spule als ein Polygonzug mit einer festgelegten Krümmung geformt sein, wobei die einzelnen Spurenelemente plan ausgeführt sein können.

Vorteilhafterweise kann die Krümmung einer definierten Kopfform des Patientenkopfes folgen.

Dadurch folgt die Krümmung der Kopfform des Patientenkopfes. Die Kopfform des Patientenkopfes kann beispielsweise in einer Datenbank mit entsprechenden passenden Krümmungen einer MRT-Spule abgespeichert sein. In Abhängigkeit von der jeweiligen Größe des Patientenkopfes wird dann eine entsprechende MRT-Spule mit einer passenden Krümmung ausgewählt. Die Krümmung sollte so gewählt werden, dass der mittlere Abstand zwischen der MRT-Spule und der Oberfläche des Patientenkopfes möglichst gering ist.

Alternativ kann eine MRT-Spule mit einer festgelegten Krümmung für einen Standardkopf unabhängig von der Größe des Patienten verwendet werden.

Vorteilhafterweise kann die MRT-Spule aus mehreren Teilen bestehen, die miteinander verbindbar sind, wobei die einzelnen Teile mittels Steckverbindungen miteinander mechanisch verbindbar sind, wobei die Steckverbindungen elektrische Verbindungen enthalten, um die einzelnen Spulenelemente elektrisch miteinander zu verbinden.

Durch die Steckverbindungen zwischen den einzelnen Teilen der MRT-Spule wird ein einfacher Zusammenbau der MRT-Spule ermöglicht. Falls ein Teil der MRT-Spule ausfällt, kann dieses Teil zeitsparend ausgetauscht werden. Die einzelnen Teile der MRT-Spule können auch jeweils eine festgelegte Krümmung aufweisen, so dass durch das Aussuchen passender Teile eine MRT-Spule zusammengesteckt werden kann, die eine gewünschte Krümmung aufweist.

Vorteilhafterweise kann die MRT-Spule eine Positionierungsvorrichtung zur Fixierung und/oder Positionierung am Patientenkopf aufweisen.

Die Positionierungsvorrichtung ermöglicht also eine Fixierung beziehungsweise Positionierung am Patientenkopf. Dabei wird also gewährleistet, dass die MRT-Spule sich relativ zum Patientenkopf während der Vermessung nicht bewegt.

Vorteilhafterweise kann die Positionierungsvorrichtung ein Bügel, ein Band, ein Gurt, ein Aufbiss, ein Luftkissen und/oder ein Vakuumkissen sein.

Ein Bügel wird beispielsweise wie bei einer Brille verwendet. Ein Band kann beispielsweise elastisch sein oder mit einem Verschluss, wie einem Klettverschluss, versehen sein. Der Patientenkopf wird relativ zur MRT-Spule mittels des Aufbisses positioniert, indem der Patient auf den Aufbiss beißt und damit die MRT-Spule an einer definierten Position relativ zu den Kiefern und damit zum Patientenkopf angeordnet wird. Ein Luftkissen und/oder ein Vakuumkissen können ebenfalls verwendet werden um den Patientenkopf relativ zur MRT-Spule zu positionieren.

Die MRT-Spule kann auch einen Gehörschutz oder Kopfhörer aufweisen, um den Patienten während der MRT-Messung vor Lärm zu schützen.

### Kurzbeschreibung der Zeichnungen

Die Erfindung wird anhand der Zeichnungen erläutert. Es zeigt, die
- Fig. 1: zeigt eine Skizze zur Verdeutlichung der Funktionsweise der vorliegenden lokalen MRT-Spule, die
- Fig. 2: eine Ausführungsform der MRT-Spule, die
- Fig. 3: Ausführungsform der MRT-Spule mit einer Öffnung um die Nase, die
- Fig. 4: Ausführungsform der MRT-Spule mit einer kuppelförmigen Aussparung um die Nase.

### Ausführungsbeispiele

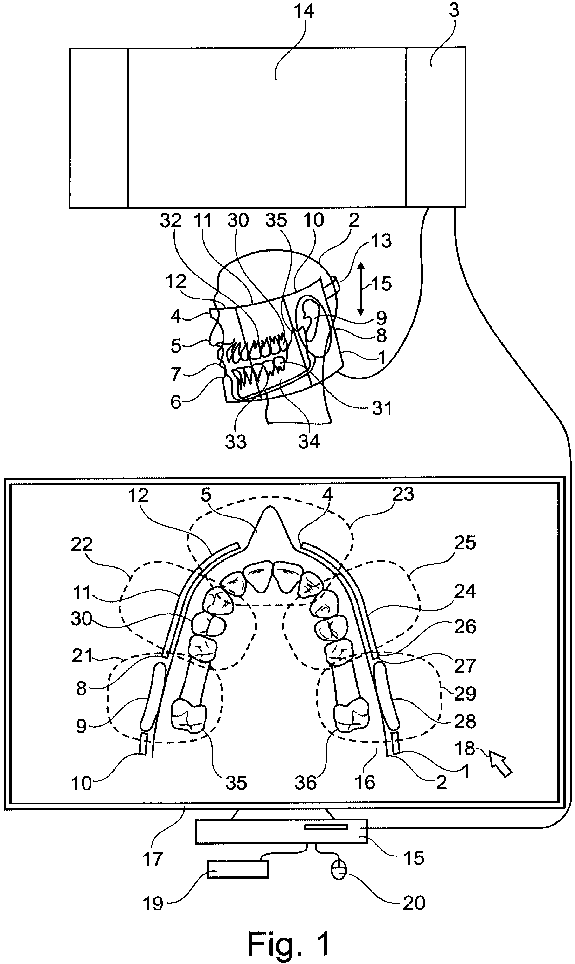

Die Fig. 1 zeigt eine Skizze zur Verdeutlichung der Funktionsweise der vorliegenden lokalen MRT-Spule 1 für eine dentale MRT-Messung eines Patientenkopfes 2 unter Verwendung einer MRT-Vorrichtung 3, wobei die MRT-Spule 1 eine erste geschlossene Aussparung 4 um eine Nase 5 in Form einer kreisförmigen Öffnung, eine zweite geschlossene Aussparung 6 um den Mund 7 in Form einer kreisförmigen Öffnung, eine dritte geschlossene Aussparung 8 um das rechte Ohr 9 in Form einer elliptischen Öffnung und eine vierte nicht dargestellte Aussparung für das linke Ohr aufweist. Die MRT-Spule 1 ist dabei aus einem ersten Spulenelement 10, einem zweiten Spulenelement 11, einem dritten Spulenelement 12 und zwei weiteren Spulenelementen aufgebaut. Die MRT-Spule 1 ist mittels einer Positionierungsvorrichtung 13 in Form eines Gurtes am Patientenkopf 2 fixiert. Die MRT-Vorrichtung 3 ist aus nicht dargestellten Elementen, wie eine Hauptmagnetfeld-Spule, mindestens eine Gradientenspule und mindestens eine Hochfrequenzspule aufgebaut. Zur MRT-Messung wird der Patientenkopf 2 zusammen mit der MRT-Spule 1 in ein Messvolumen 14 der MRT-Vorrichtung 3 eingebracht, wie durch den Pfeil 15 angedeutet ist. Das Positionieren des Patientenkopfes 2 relativ zur MRT-Vorrichtung 3 kann dabei manuell durch einen Patientenstuhl oder eine Patientenliege erfolgen.

Die Aufnahmedaten der MRT-Spule 1 werden an die MRT-Vorrichtung und dann weiter an einen Computer 15 weitergeleitet, um daraus eine dreidimensionale MRT-Aufnahme 16 zu berechnen, die mittels einer Darstellungsvorrichtung 17, wie eines Monitors, dargestellt ist. Zur Navigation innerhalb der MRT-Aufnahme 16 kann ein Benutzer einen virtuellen Cursor 18 unter Verwendung der Eingabemittel, wie einer Tastatur 19 und einer Maus 20, bedienen. Zur Verdeutlichung ist die MRT-Spule 1 relativ zur MRT-Aufnahme 16 dargestellt. Das erste Spulenelement 10 um das rechte Ohr 9 mit der dritten geschlossenen Aussparung 8 weist einen ersten Aufnahmebereich 21 auf, der gestrichelt dargestellt ist.

Das zweite Spulenelement 11 ohne Aussparung weist einen zweiten Aufnahmebereich 22 auf. Das dritte Spulenelement 12 um die Nase 5 mit der ersten geschlossenen Aussparung 4 weist einen dritten Aufnahmebereich 23 auf. Das vierte Spulenelement 24 ohne Aussparung weist einen vierten Aufnahmebereich 25 auf. Das fünfte Spulenelement 26 mit einer vierten geschlossenen Aussparung 27 um das rechte Ohr 28 weist einen fünften Aufnahmebereich 29 auf. Die einzelnen Aufnahmebereiche 21, 22, 23, 25, und 29 der einzelnen Spulenelemente überlappen sich teilweise und sind damit zusammenhängend, sodass aufzunehmende Objektbereiche, wie die Zähne 30 eines Oberkiefers, die Zähne 31 eines Unterkiefers, die Zahnwurzeln 32 des Oberkiefers, die Zahnwurzeln 33 des Unterkiefers, ein Kieferknochen 34, ein linkes Kiefergelenk 35 und/oder ein rechtes Kiefergelenk 37 aufgenommen werden und anschließend in der MRT-Aufnahme 16 dargestellt werden. Die MRT-Spule 1 und die einzelnen Spulenelemente 10, 11, 12, 24 und 26 weisen eine festgelegte Krümmung auf, die der definierten Kopfform des Patientenkopfes 2 folgt, wie aus der MRT-Aufnahme 16 ersichtlich ist. Dabei wird der Abstand zwischen der MRT-Spule 1 und der Oberfläche des Patientenkopfes 2 möglichst gering gehalten. Dadurch wird der Abstand zwischen der MRT-Spule 1 und den aufzunehmenden Objektbereichen 30, 35 und 36 möglichst gering gehalten, so dass die Signalausbeute und damit die Bildqualität der MRT-Aufnahme 16 verbessert wird.

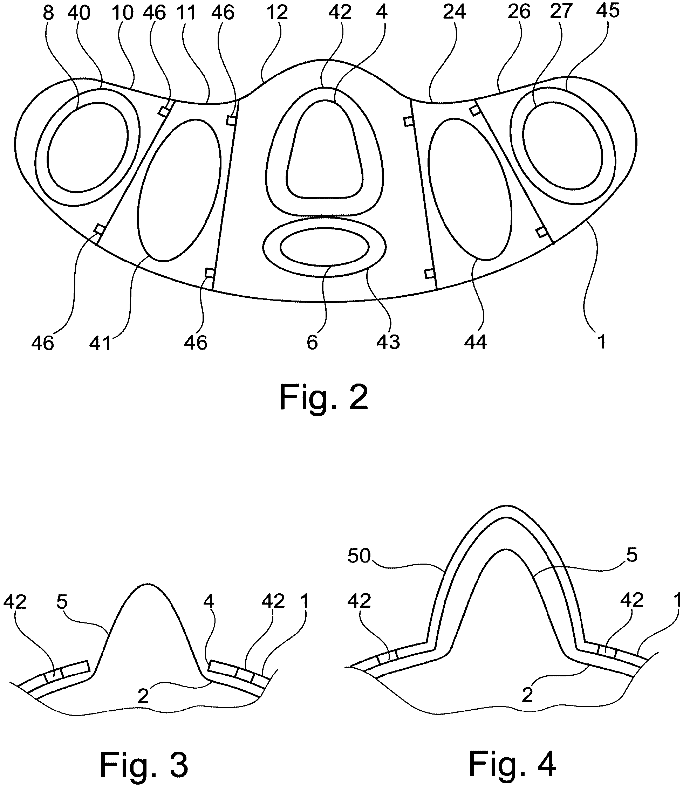

Die Fig. 2 zeigt eine Ausführungsform der MRT-Spule 1, bestehend aus dem ersten Spulenelement 10 mit der dritten Aussparung 8 für das linke Ohr 9, dem zweiten Spulenelement 11 ohne Aussparung, dem dritten Spulenelement 12 mit der ersten Aussparung 4 für die Nase 5 und der zweiten Aussparung 6 für den Mund 7, den vierten Spulenelement 24 ohne Aussparung und dem fünften Spulenelement 26 mit der vierten Aussparung 27 für das rechte Ohr 28. Im ersten Spulenelement 10 ist um die dritte Aussparung 8 eine Spule 40 zur Vermessung des ersten Aufnahmebereichs 21 angeordnet. Im zweiten Spulenelement 11 ist eine zweite Spule 41 zur Vermessung des zweiten Aufnahmebereichs 22 angeordnet. Im dritten Spulenelement 12 ist um die erste Aussparung 4 eine dritte Spule 42 zur Vermessung des dritten Aufnahmebereichs 23 angeordnet. Zusätzlich ist um die zweite Aussparung 6 eine vierte Spule 43 angeordnet. Im vierten Spulenelement 24 ist eine fünfte Spule 44 zur Vermessung des vierten Aufnahmebereichs 25 angeordnet. Im fünften Spulenelement 26 ist um die Aussparung 27 eine sechste Spule 45 zur Vermessung des fünften Aufnahmebereichs 29 angeordnet. Die einzelnen Spulenelemente 10, 11, 12, 24 und 26 werden mittels Steckverbindungen 46 zusammengesteckt, wobei die Steckverbindungen elektrische Verbindungen enthalten, um die einzelnen Spulenelemente elektrisch miteinander zu verbinden. Die einzelnen Spulen 40, 41, 42, 43, 44 und 45 können parallel oder auch seriell ausgelesen werden.

Die Fig. 3 zeigt eine Ausführungsform der MRT-Spule 1 mit einer ersten geschlossenen Aussparung 4 in Form einer Öffnung um die Nase 5 mit der Spule 42.

Die Fig. 4 zeigt eine Skizze einer weiteren Ausführungsform der MRT-Spule 1 mit einer ersten geschlossenen Aussparung in Form einer kuppelförmigen Aussparung 50, die um die Nase 5 angeordnet ist. Durch die kuppelförmige Aussparung 50 um die Nase 5 wird gewährleistet, dass die Spule 42 möglichst nah an der Oberfläche des Patientenkopfes verläuft.

### Bezugszeichen

- 1: MRT-Spule
- 2: Patientenkopf
- 3: MRT-Vorrichtung
- 4: erste geschlossene Aussparung
- 5: Nase
- 6: zweite geschlossene Aussparung
- 7: Mund
- 8: dritte geschlossene Aussparung
- 9: rechtes Ohr
- 10: erstes Spulenelement
- 11: zweites Spulenelement
- 12: drittes Spulenelement
- 13: Positionierungsvorrichtung
- 14: Messvolumen
- 15: Computer
- 16: MRT-Aufnahme
- 17: Darstellungsvorrichtung
- 18: virtueller Cursor
- 19: Tastatur
- 20: Maus
- 21: erster Aufnahmebereich
- 22: zweiter Aufnahmebereich
- 23: dritter Aufnahmebereich
- 24: viertes Spulenelement
- 25: vierter Aufnahmebereich
- 26: fünftes Spulenelement
- 27: vierte geschlossene Aussparung
- 28: rechtes Ohr
- 29: fünfter Aufnahmebereich
- 30: aufzunehmende Objektbereiche
- 31: Zähne
- 32: Zahnwurzeln des Oberkiefers
- 33: Zahnwurzeln des Unterkiefers
- 34: Kieferknochen
- 35: linkes Kiefergelenk
- 36: aufzunehmender Objektbereich
- 37: rechtes Kiefergelenk
- 40: erste Spule
- 41: zweite Spule
- 42: dritte Spule
- 43: vierte Spule
- 44: fünfte Spule
- 45: sechste Spule
- 46: Steckverbindungen
- 50: kuppelförmige Aussparung

## Patentansprüche

1. Lokale MRT-Spule (1) für eine dentale MRT-Messung eines Patientenkopfes (2), umfassend mindestens zwei Spulenelemente (10, 12, 13, 24, 26), **dadurch gekennzeichnet, dass** die lokale MRT-Spule (1) mindestens eine geschlossene Aussparung (4) für mindestens einen Teil einer Nase (5) des Patientenkopfes (2) aufweist, wobei eine Spule (42) mindestens eines Spulenelements (12) um die geschlossene Aussparung (4) herum angeordnet ist und den mindestens einen Teil der Nase (5) des Patientenkopfes (2) umschließt.

2. Lokale MRT-Spule (1) nach Anspruch 1, **dadurch gekennzeichnet, dass** die MRT-Spule (1) eine zweite geschlossene Aussparung (8, 27) für mindestens einen Teil eines Mundes (7) und/oder mindestens einen Teil eines Ohres (9, 28) des Patientenkopfes (2) in einem zweiten Spulenelement (10, 26) aufweist, wobei eine Spule (40, 45) des zweiten Spulenelements (10, 26) um die zweite geschlossene Aussparung (8, 27) herum angeordnet ist und wobei die zweite geschlossene Aussparung (8, 27) um den Mund (7), das linke Ohr (9) oder das rechte Ohr (28) angeordnet ist.

3. Lokale MRT-Spule (1) nach Anspruch 2, **dadurch gekennzeichnet, dass** mindestens eine weitere geschlossene Aussparung (8, 27) in einem weiteren Spulenelement (10, 26) um den Mund (7), das linke Ohr (9) oder das rechte Ohr (28) angeordnet ist.

4. Lokale MRT-Spule (1) nach einem der Ansprüche 1-3, **dadurch gekennzeichnet, dass** jedes der Spulenelemente (10, 12, 13, 24, 26) einen durch das Spulenelement definierten begrenzten Aufnahmebereich (21, 22, 23, 25, 29) aufnimmt.

5. Lokale MRT-Spule (1) nach Anspruch 4 **dadurch gekennzeichnet, dass** die MRT-Spule (1) mindestens ein weiteres Spulenelement (11, 24) ohne einer Aussparung aufweist, wobei die von den einzelnen Spulenelementen (10, 12, 13, 24, 26) umschlossenen Aufnahmebereiche (21, 22, 23, 25, 29) zusammenhängend sind.

6. Lokale MRT-Spule (1) nach einem der Ansprüche 1-5, **dadurch gekennzeichnet, dass** die einzelnen Spulenelemente (10, 12, 13, 24, 26) relativ zu einer Symmetrieebene des Patientenkopfes (2) symmetrisch angeordnet sind.

7. Lokale MRT-Spule (1) nach einem der Ansprüche 1-6, **dadurch gekennzeichnet, dass** die MRT-Spule (1) auch als eine Anregungsspule verwendet wird.

8. Lokale MRT-Spule (1) nach einem der Ansprüche 1-7, **dadurch gekennzeichnet, dass** die mindestens zwei Spulenelemente (10, 12, 13, 24, 26) möglichst nah an einem aufzunehmenden Objektbereich positioniert werden, wobei der Objektbereich mindestens einen Zahnbereich (30), ein linkes Kiefergelenk (35) und/oder ein rechtes Kiefergelenk (36) umfasst.

9. Lokale MRT-Spule (1) nach einem der Ansprüche 5-8, **dadurch gekennzeichnet, dass** die durch die einzelnen Spulenelemente (10, 12, 13, 24, 26) definierten Aufnahmebereiche (21, 22, 23, 25, 29) zumindest einen halben Oberkiefer und/oder einen halben Unterkiefer abbilden.

10. Lokale MRT-Spule (1) nach einem der Ansprüche 5-9, **dadurch gekennzeichnet, dass** die von den einzelnen Spulenelementen (10, 12, 13, 24, 26) umfassten Aufnahmebereiche (21, 22, 23, 25, 29) den gesamten Oberkiefer und/oder den gesamten Unterkiefer abbilden.

11. Lokale MRT-Spule (1) nach einem der Ansprüche 1-10, **dadurch gekennzeichnet, dass** die MRT-Spule (1) und/oder die einzelnen Spulenelemente (10, 12, 13, 24, 26) mit einer festgelegten Krümmung gekrümmt geformt sind.

12. Lokale MRT-Spule (1) nach Anspruch 11, **dadurch gekennzeichnet, dass** die Krümmung einer definierten Kopfform des Patientenkopfes (2) folgt.

13. Lokale MRT-Spule (1) nach einem der Ansprüche 1-12, **dadurch gekennzeichnet, dass** die MRT-Spule (1) aus mehreren Teilen besteht, die miteinander verbindbar sind, wobei die einzelnen Teile mittels Steckverbindungen (46) miteinander mechanisch verbindbar sind, wobei die Steckverbindungen (46) elektrische Verbindungen enthalten, um die einzelnen Spulenelemente (10, 12, 13, 24, 26) elektrisch miteinander zu verbinden.

14. Lokale MRT-Spule (1) nach einem der Ansprüche 1-13, **dadurch gekennzeichnet, dass** die MRT-Spule (1) eine Positionierungsvorrichtung (13) zur Fixierung und/oder Positionierung am Patientenkopf (2) aufweist.

15. Lokale MRT-Spule (1) nach Anspruch 14, **dadurch gekennzeichnet, dass** die Positionierungsvorrichtung ein Bügel, ein Band, ein Gurt (13), ein Aufbiss, ein Luftkissen und/oder ein Vakuumkissen ist.
